# EUROPEAN PATENT APPLICATION

(11) **EP 4 160 227 A1**
(43) Date of publication of application: **05.04.2023**
(21) Application number: 21814189.3
(22) Date of filing: 27.05.2021
(51) Int. Cl.: G01R 21/00, H02J 13/00, G06Q 10/06, G05B 19/418, G06Q 50/04

(54) **STATE DETERMINATION DEVICE, STATE DETERMINATION SYSTEM, PRODUCTION SYSTEM, PROCESS MANAGEMENT DEVICE, AND STATE DETERMINATION METHOD**

(30) Priority: 27.05.2020 JP 2020092440; 27.05.2020 JP 2020092439; 29.05.2020 JP 2020094705
(71) Applicant: Kyocera Corporation, Kyoto-shi Kyoto 612-8501 (JP)
(72) Inventor: OHIRA, Masahiro, Kyoto-shi, Kyoto 612-8501 (JP); TAKARABE, Shohei, Kyoto-shi, Kyoto 612-8450 (JP); MAEDA, Takeshi, Kyoto-shi, Kyoto 612-8501 (JP); MORI, Keisuke, Kyoto-shi, Kyoto 612-8501 (JP); HATAI, Kohta, Kyoto-shi, Kyoto 612-8501 (JP); HANAI, Akihiro, Kyoto-shi, Kyoto 612-8501 (JP); SASAKI, Naoya, Kyoto-shi, Kyoto 612-8450 (JP)
(74) Representative: TBK
(86) International application number: PCT/JP2021/020139
(87) International publication number: WO 2021/241671

(57) **Abstract**

A state determination device (10100) includes: a signal acquiring unit (1030) configured to acquire a signal corresponding to each of a plurality of electrical wiring lines constituting the electrical equipment X and indicating an energization state of each electrical wiring line in association with each electrical wiring line; and a state determination unit (1011) configured to determine an operating state of the target electrical equipment that can be distinguished by a combination of the energization states corresponding the plurality of electrical wiring lines.

## Description

### TECHNICAL FIELD

The present disclosure relates to a state determination device, a state determination system, a state determination method, a production system, and a step management device that determine a state of electrical equipment.

### BACKGROUND OF INVENTION

In a plant or the like, grasping the operating state of installed facilities is important in order to manage the operating schedule of the facilities and to grasp the operating state of the plant.

Therefore, Patent Document 1 discloses a system having a sensor installed in a power supply line of a facility, the system monitors an operating state of the facility by measuring current flowing through the power supply line.

### CITATION LIST

### PATENT LITERATURE

Patent Document 1: JP 2018-159609 A

### SUMMARY

A state determination device according to one aspect of the present disclosure includes: a signal acquiring unit configured to acquire a signal corresponding to each of a plurality of electrical wiring lines constituting target electrical equipment in association with each of the electrical wiring lines, the signal indicating an energization state of each of the electrical wiring lines; and a state determination unit configured to determine an operating state of the target electrical equipment that can be distinguished by a combination of the energization states of the plurality of electrical wiring lines.

A state determination system according to one aspect of the present disclosure includes: the state determination device; and a current sensor that is installed in each of a plurality of electrical wiring lines constituting target electrical equipment, the current sensor configured to transmit a signal indicating an energization state of the electrical wiring line based on a measured current value, in which the signal acquiring unit acquires the signal from the current sensor.

A state determination method according to one aspect of the present disclosure is a state determination method for determining a state of target electrical equipment, the state determination method including, signal acquisition of acquiring a signal corresponding to each of a plurality of electrical wiring lines constituting the target electrical equipment in association with each of the electrical wiring lines, the signal indicating an energization state of each of the electrical wiring lines; and state determination of determining an operating state of the target electrical equipment that can be distinguished by a combination of the energization states corresponding to the plurality of electrical wiring lines.

### BRIEF DESCRIPTION OF THE DRAWINGS

FIG. 1 is a functional block diagram illustrating an outline of a state determination system according to the present embodiment.
FIG. 2 is a view illustrating an outline of a configuration of a measurement unit.
FIG. 3 is a view illustrating an example of a determination table.
FIG. 4 is a flowchart showing a flow of processing in a state determination device.

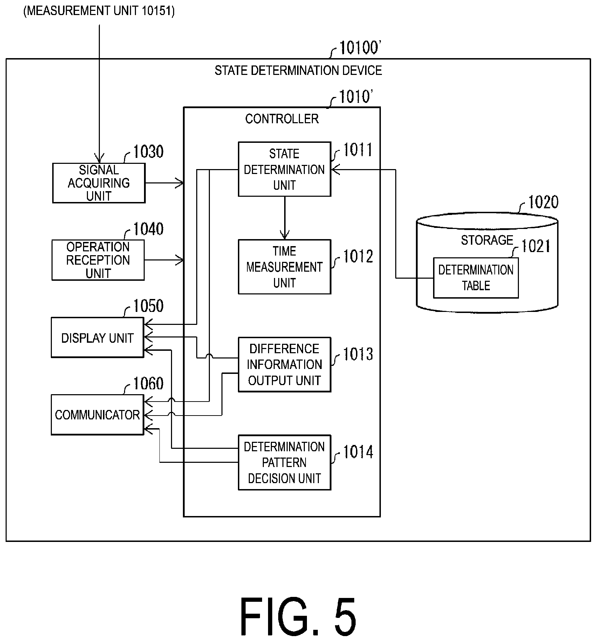

FIG. 5 is a functional block diagram illustrating a configuration of a main part of a state determination device according to another embodiment of the present disclosure.
FIG. 6 illustrates an outline of a production system of the present disclosure.
FIG. 7 illustrates a display screen on a display of the present disclosure.
FIG. 8 is a block diagram illustrating an example of a detector according to the present embodiment and a configuration of a main part of a step management device.
FIG. 9 is a view illustrating an overall outline of a step management system according to the present embodiment.
FIG. 10 is a view illustrating an example of determination information.
FIG. 11 is a flowchart showing a flow of processing in the step management device.
FIG. 12 is a view illustrating another example of detecting a tag by the detector.
FIG. 13 is a block diagram illustrating an example of a presentation unit according to another embodiment of the present disclosure and a configuration of a main part of a step management device.
FIG. 14 is a view illustrating another example of determination information.
FIG. 15 is a block diagram illustrating an example of a detector according to another embodiment of the present disclosure and a configuration of a main part of a step management device.
FIG. 16 is a block diagram illustrating an example of a reading unit according to another embodiment of the present disclosure and a configuration of a main part of a step management device.
FIG. 17 is a view illustrating another example of determination information.

### DESCRIPTION OF EMBODIMENTS

### First Embodiment

### Overall Outline of First Embodiment

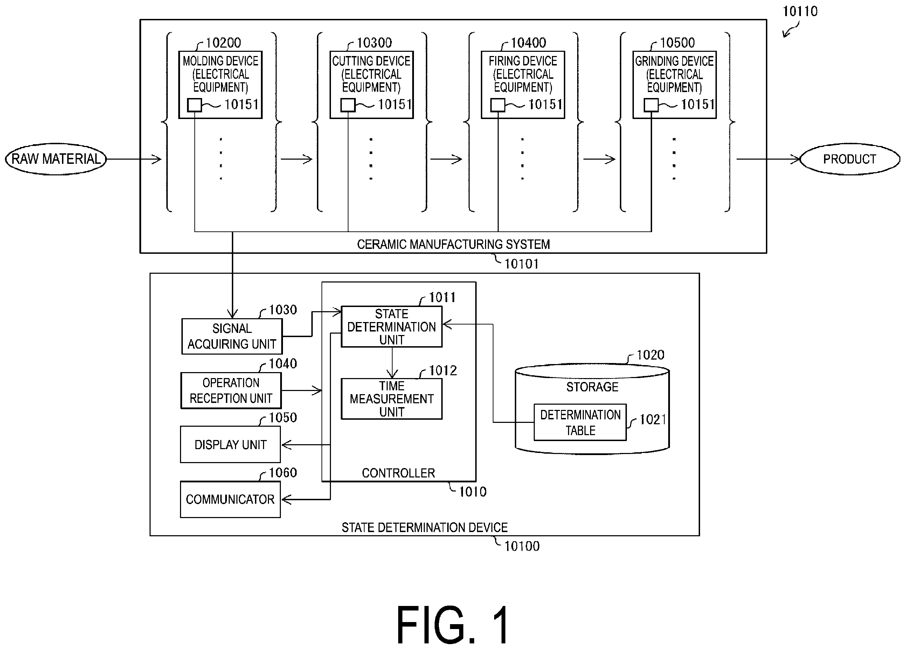

An embodiment of the present disclosure will be described in detail below. First, a state determination system 10110 according to the present embodiment will be described with reference to FIG. 1. FIG. 1 is a view illustrating an outline of the state determination system 10110 according to the present embodiment. In the present embodiment, as a facility (target electrical equipment) whose state is to be determined by a state determination device 10100, a facility related to manufacturing of a ceramic will be described as an example, but the present invention is not limited to this. Any facility including electrical wiring line may be used, and the facility may be any of various manufacturing plants for machinery or the like, food plants, printing and paper plants, petrochemical plants, or the like. The facility may be not only a facility installed in plants or the like but also a facility installed in stores or the like.

As illustrated in FIG. 1, the state determination system 10110 according to the present embodiment includes a ceramic manufacturing system 10101 and the state determination device 10100.

In the state determination system 10110 according to the present embodiment, for each facility in the ceramic manufacturing system 10101, the current flowing through a plurality of electrical wiring lines of the facility is measured by a measurement unit 10151, and the state determination device 10100 determines the state of the facility using the measurement result. The state determination system 10110 can accurately determine the state of a facility by measuring not only a power supply line of each facility but also each electrical wiring line constituting the facility and determining the state of the facility.

### Ceramic Manufacturing System

As illustrated in FIG. 1, the ceramic manufacturing system 10101 includes one or more devices from the group consisting of a molding device 10200, a cutting device 10300, a firing device 10400, and a grinding device 10500 that are used for processing of each step for manufacturing a ceramic.

In the ceramic manufacturing system 10101, a ceramic product is manufactured through the following steps. First, there is a raw material of a ceramic, and the raw material of the ceramic is molded by the molding device 10200 to form a ceramic molded body. Next, the ceramic molded body is cut by the cutting device 10300, the ceramic molded body after cutting is fired by the firing device 10400, and a ceramic fired body after firing is ground by the grinding device 10500 to manufacture a ceramic product.

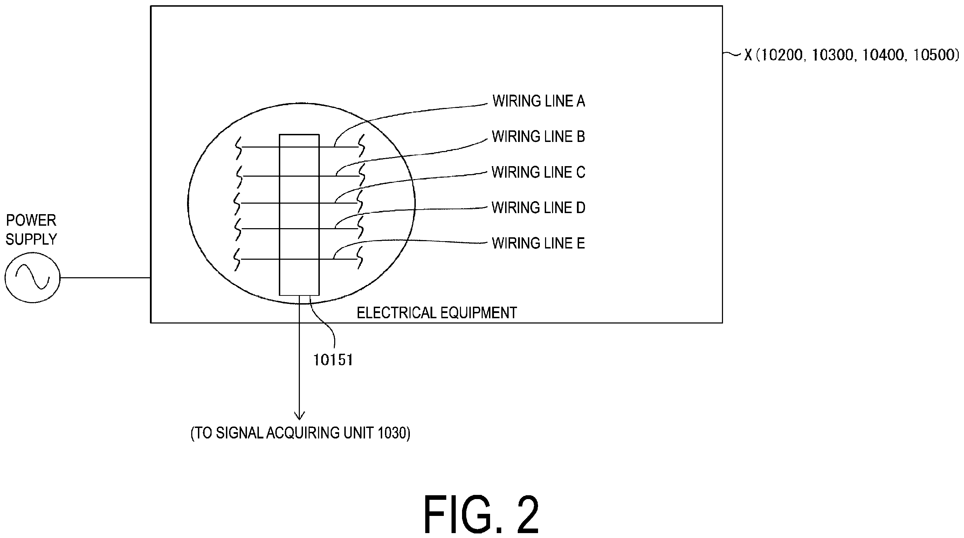

Each device includes the measurement unit 10151 that measures current flowing through the electrical wiring line and transmits a measurement result associated with the electrical wiring line. This will be described in more detail with reference to FIG. 2. FIG. 2 is a diagram for explaining an example of measurement by the measurement unit 10151. In FIG. 2, the facilities (molding device 10200, cutting device 10300, firing device 10400, and grinding device 10500) included in the ceramic manufacturing system 10101 are collectively referred to as electrical equipment X.

The measurement unit 10151 is provided with a current sensor for each electrical wiring line of the electrical equipment X, measures current for each electrical wiring line, associates a measurement result (energization state) with the electrical wiring line, and transmits the measurement result to the state determination device 10100 as a signal. The measurement unit 10151 may transmit each measurement result to a different port for each electrical wiring line provided in a signal acquiring unit 1030 of the state determination device 10100, and the state determination device 10100 side may recognize the corresponding electrical wiring line by the port.

As illustrated in FIG. 2, there are assumed to be a wiring line A, a wiring line B, a wiring line C, a wiring line D, and a wiring line E as electrical wiring lines constituting the electrical equipment X. In this case, the measurement unit 10151 measures the current of each of the wiring lines, and transmits a measurement result indicating the energization state to the state determination device 10100 in association with the wiring line. The measurement result transmitted by the measurement unit 10151 may indicate whether a current is flowing, or whether a current larger than a predetermined value is flowing. For example, with two thresholds Th1 and Th2 provided, the measurement result may indicate one of the three stages of measurement value < Th1, Th1 < measurement value ≤ Th2, and Th2 < measurement value. The measurement result may indicate one of four or more stages with three or more threshold values provided.

Then, the measurement unit 10151 transmits, to the state determination device 10100, a signal indicating the measurement result and the corresponding electrical wiring line. The signal transmitted by the measurement unit 10151 may be a numerical value (digital signal) or may display color or light (brightness) that is acquired by the state determination device 10100.

### State Determination Device

The state determination device 10100 includes a controller 1010, a storage 1020, a signal acquiring unit 1030, an operation reception unit 1040, a display unit 1050, and a communicator 1060.

The controller 1010 executes processing in the state determination device 10100, and includes a state determination unit 1011 and a time measurement unit (time calculation unit) 1012. Details of processing in the state determination unit 1011 and the time measurement unit 1012 will be described later.

The storage 1020 is a storage device provided in the state determination device 10100, and the state determination unit 1011 stores a determination table 1021 used for determination of the state of the electrical equipment X.

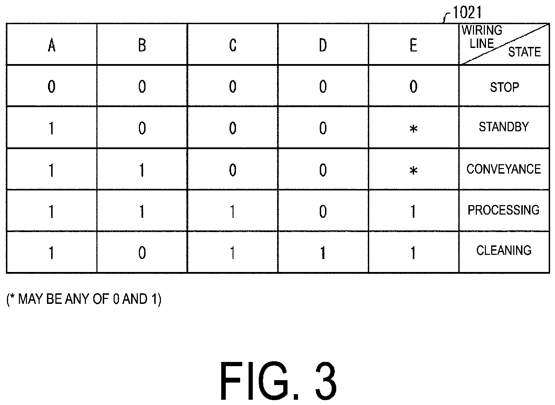

FIG. 3 illustrates an example of the determination table 1021. As illustrated in FIG. 3, the determination table 1021 associates a combination of measurement results for each electrical wiring line with the state of the electrical equipment X. In the example illustrated in FIG. 3, the measurement result is indicated by "0" or "1", where "0" indicates that no current flows through the electrical wiring line, and "1" indicates that a current flows through the electrical wiring line. As described above, not whether a current flows through the electrical wiring line but whether a current of a predetermined value or more flows through the electrical wiring line may be indicated. When the measurement result has three or more stages, values are only required to be set in a distinguishable manner as appropriate.

The determination table 1021 illustrated in FIG. 3 indicates that, for example, the electrical equipment X is in a stopped state in a case of the wiring line A "0", the wiring line B "0", the wiring line C "0", the wiring line D "0", and the wiring line E "0"; the electrical equipment X is in a standby state in a case of the wiring line A "1", the wiring line B "0", the wiring line C "0", the wiring line D "0", and the wiring line E "*"; the electrical equipment X is in a conveyance state in a case of the wiring line A "1", the wiring line B "1", the wiring line C "0", the wiring line D "0", and the wiring line E "*"; the electrical equipment X is in a processing state (when the electrical equipment X is a device that performs processing) in a case of the wiring line A "1", the wiring line B "1", the wiring line C "1", the wiring line D "0", and the wiring line E "1"; and the electrical equipment X is in a cleaning state in a case of the wiring line A "1", the wiring line B "0", the wiring line C "1", the wiring line D "1", and the wiring line E "1". The "*" described above indicates that the value may be either "0" or "1".

The signal acquiring unit 1030 acquires and transmits, to the state determination unit 1011, a signal indicating a measurement result and a corresponding electrical wiring line from the measurement unit 10151 provided in each device of the ceramic manufacturing system 10101. The signal acquiring unit 1030 may include a plurality of ports for acquiring a measurement result for each electrical wiring line of the electrical equipment X, and may acquire the measurement result and the corresponding electrical wiring line by using the measurement result received at a certain port as a measurement result in the corresponding electrical wiring line.

The operation reception unit 1040 receives a user operation on the state determination device 10100, and is, for example, a keyboard, a mouse, or the like. The display unit 1050 and the operation reception unit 1040 may be integrated as a touch panel or the like.

The display unit 1050 is a display device that displays information, and is, for example, a liquid crystal display, a plasma display, an organic EL display, or the like.

The communicator 1060 communicates with external equipment, and transmits a determination result of the state determination unit 1011 to the external equipment, for example.

Details of State Determination Unit and Time Measurement Unit The state determination unit 1011 determines the state of the electrical equipment X using the signal indicating the measurement result of the electrical wiring line of the electrical equipment X acquired via the signal acquiring unit 1030. The state of the electrical equipment X includes a state in which the electrical equipment X is energized, that is, an operating state and a stopped state. The operating state is a state in which the electrical equipment X is operating in some way, and there are a plurality of operating states.
For example, in the example illustrated in FIGs. 2 and 3, the operating state includes four states: the standby state, the conveyance state, the processing state, and the cleaning state. When there are five electrical wiring lines constituting the electrical equipment X as illustrated in FIG. 2, that is, the wiring line A, the wiring line B, the wiring line C, the wiring line D, and the wiring line E, with the measurement results of the wiring line A "1", the wiring line B "1", the wiring line C "1", the wiring line D "0", and the wiring line E "1", and determination is made using the determination table 1021 of FIG. 3, the state determination unit 1011 determines that the electrical equipment X is in the processing state. When the measurement results are the wiring line A "1", the wiring line B "0", the wiring line C "1", the wiring line D "1", and the wiring E line "1", the state determination unit 1011 determines that the electrical equipment X is in the cleaning state.

The time measurement unit 1012 measures time of the state determined by the state determination unit 1011. For example, in response to the determination result of the state determination unit 1011, the time measurement unit 1012 measures the time of the state determined by the state determination unit 1011 such that from 8:00 AM to 9:00 AM is the conveyance state, from 9:00 AM to 4:00 PM is the processing state, and from 4:00 PM to 6:00 PM is the cleaning state.

As described above, the state determination device 10100 according to the present embodiment includes: the signal acquiring unit 1030 that acquires a signal corresponding to each of a plurality of electrical wiring lines (wiring line A to wiring line E) constituting the electrical equipment X in association with each of the electrical wiring lines, the signal indicating an energization state of each of the electrical wiring lines; and the state determination unit 1011 that determines the state of the electrical equipment X that can be distinguished by a combination of the energization states of the plurality of electrical wiring lines.

In the state determination device 10100 according to the present embodiment, a plurality of operating states are determined by the state determination unit 1011, and the state determination unit 1011 specifies which state, among the plurality of states, the electrical equipment X is in, by using a combination of the energization states.

The state determination device 10100 according to the present embodiment includes the time measurement unit 1012 that calculates the time at which the state determination unit 1011 determines that the electrical equipment X is in a certain state.

### Flow of Processing

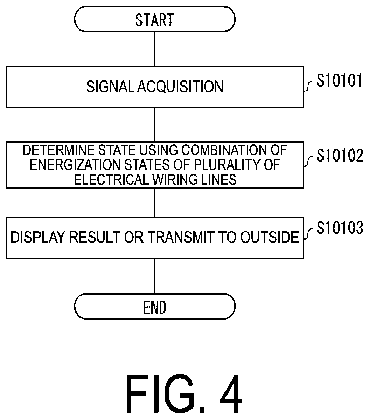

Next, the flow of processing in the state determination device 10100 will be described with reference to FIG. 4. FIG. 4 is a flowchart showing the flow of processing of the state determination device 10100. As shown in FIG. 4, the state determination device 10100 first acquires a signal indicating a measurement result of each electrical wiring line and the corresponding electrical wiring line from the measurement unit 10151 (S10101: signal acquisition step). Next, with reference to the determination table 1021, the state determination unit 1011 of the state determination device 10100 determines the state of the corresponding electrical equipment X using the combination of the energization states indicated by the acquired signal (S10102: state determination step). Then, the determination result is displayed on the display unit 1050 or output to the external equipment via the communicator 1060 (S10103). Both display on the display unit 1050 and output to the external equipment may be performed.

### First Embodiment 2

Another embodiment of the present disclosure will be described below. Note that, for convenience of description, a member having the same function as that of a member described in the embodiments described above is denoted by the same reference sign, and description thereof will not be repeated.

In the present embodiment, information for deciding upon the electrical wiring line for determining the state of the electrical equipment X is presented.

Specifically, a controller 1010' of a state determination device 10100' according to the present embodiment includes a difference information output unit 1013 and a determination pattern decision unit (minimum combination decision unit) 1014 in addition to the configuration of the above-described first embodiment. Only one of the difference information output unit 1013 and the determination pattern decision unit 1014 may be included.

The difference information output unit 1013 compares the measurement results of the electrical wiring line in the electrical equipment X in a state that the user desires to determine, in other words, the state that the user desires, and in another state, and displays, on the display unit 1050, difference information indicating whether there is a difference or outputs the difference information to the external equipment via the communicator 1060.

With the difference information, it is possible to identify the electrical wiring line that can determine whether the electrical equipment X is in a state desired by the user. Therefore, by adding the measurement result of the specified electrical wiring line to the determination table 1021, whether the electrical equipment X is in the state desired by the user can be determined.

It is possible to cause the difference information output unit 1013 to recognize the measurement result of the electrical wiring line of the electrical equipment X when in the state desired by the user, for example, by setting the electrical equipment X to the state desired by the user and inputting the fact of being in the state to the state determination device 10100 via the operation reception unit 1040. Similarly, the difference information output unit 1013 can be caused to recognize also the measurement result of the electrical wiring line of the electrical equipment X when the electrical equipment X is in a state that is not desired by the user, by inputting the fact that the electrical equipment X is not in the state to the state determination device 10100 via the operation reception unit 1040. This allows the difference information output unit 1013 to compare the measurement result of the electrical wiring line when the electrical equipment X is in the desired state with the measurement result of the electrical wiring line when the electrical equipment X is not in the desired state, and generate and output difference information.

The determination pattern decision unit 1014 compares combinations of the measurement results of the electrical wiring lines among the plurality of states in the electrical equipment X, and decides upon the minimum combination of the electrical wiring lines with which the plurality of states can be distinguished from one another. Then, the decided combination is displayed on the display unit 1050 or output to external equipment via the communicator 1060.

This is performed, for example, by inputting, for each state of the electrical equipment X, the fact of being in the state to the state determination device 10100 via the operation reception unit 1040. The determination pattern decision unit 1014 stores the measurement result of the electrical wiring line at that time for each state of the electrical equipment X having been input, and compares the measurement results of the electrical wiring line in each of the plurality of states, thereby deciding upon the combination of the electrical wiring lines with which the states of the electrical equipment X can be distinguished. Using the example of the determination table 1021 illustrated in FIG. 3 for description, when it is desired to distinguish the standby state, the conveyance state, and the processing state, these can be distinguished by a combination of the wiring line A, the wiring line B, and the wiring line C. Therefore, in this case, the determination pattern decision unit 1014 decides upon the combination of the wiring line A, the wiring line B, and the wiring line C as the minimum combination.

As described above, the state determination device 10100' according to the present embodiment includes the difference information output unit 1013 that compares the energization state of a certain electrical wiring line in a state desired to be determined in the electrical equipment X and in another state and outputs difference information indicating whether there is a difference.

The state determination device 10100' according to the present embodiment includes the determination pattern decision unit 1014 that compares combinations of the energization states of the plurality of electrical wiring lines among the plurality of states of the electrical equipment X and decides upon the minimum combination of the energization states with which the plurality of states can be distinguished from one another.

### Example of Software Implementation

A control block (in particular, the state determination unit 1011, the time measurement unit 1012, the difference information output unit 1013, and the determination pattern decision unit 1014) of the state determination device 10100 may be implemented by a logic circuit (hardware) formed in an integrated circuit (IC chip) or the like, or may be implemented by software.

In the latter case, the state determination device 10100 includes a computer that executes a command of a program that is software for implementing each function. This computer includes, for example, at least one processor (control device) and at least one computer-readable recording medium storing the program. Then, in the computer, the processor reads the above program from the recording medium and executes the read program to achieve the object of the present disclosure. As the processor, a central processing unit (CPU) can be used, for example. As the recording medium, a "non-transitory tangible medium" such as, for example, a read only memory (ROM), a tape, a disk, a card, a semiconductor memory, a programmable logic circuit, and the like can be used. Additionally, a random access memory (RAM) for loading the above program may be further provided. The above program may be supplied to the computer via any transmission medium (communication network, broadcast wave, and the like) capable of transmitting the program. Further, one aspect of the present disclosure may be implemented in the form of data signals embedded in a carrier wave in which the above program is embodied by electronic transmission.

### Supplementary Note

The present disclosure can be expressed as follows.

A state determination device according to one aspect of the present disclosure includes: a signal acquiring unit that acquires a signal corresponding to each of a plurality of electrical wiring lines constituting target electrical equipment in association with each of the electrical wiring lines, the signal indicating an energization state of each of the electrical wiring lines; and a state determination unit that determines an operating state of the target electrical equipment that can be distinguished by a combination of the energization states of the plurality of electrical wiring lines.

According to the above configuration, since the combination of the energization states of the plurality of electrical wiring lines is used for determination of the operating state of a target home electrical appliance, the operating state of the target electrical equipment can be accurately determined as compared with a case of determination only from the energization state of the power supply line. The operating state is a state in which the electrical equipment is energized, and is a state in which the electrical equipment is operating in some way.

In the state determination device according to one aspect of the present disclosure, a plurality of operating states may be determined by the state determination unit, and the state determination unit may identify, by using a combination of the energization states, which of the plurality of operating states the target electrical equipment may be in.

According to the above configuration, even if the target electrical equipment can have a plurality of operating states, the state the target electrical equipment is in can be identified.

For example, when the combination of the energization states of the electrical wiring lines with certain target electrical equipment being in an operating state α is "wiring line A energized and wiring line B energized", and the combination of the energization states of the electrical wiring lines in an operating state β is "wiring line A energized and wiring line B not energized", the energization states of the wiring line A and the wiring line B can be used to distinguish and determine the operating states α and β.

The state determination device according to one aspect of the present disclosure may include the time calculation unit that calculates a time for which the state determination unit makes a determination of being in a certain operating state.

According to the above configuration, the time that the target electrical equipment is in a certain operating state in a predetermined period can be calculated. Calculating a certain operating time in a predetermined period enables an operating rate of the certain operating state to be obtained.

The state determination device according to one aspect of the present disclosure may include a difference information output unit configured to compare an energization state of a certain electrical wiring line in an operating state desired to be determined in the target electrical equipment and in another state, and outputs difference information indicating whether there is a difference.

According to the above configuration, it is possible to identify the electrical wiring line having a different energization state when the target electrical equipment is in the operating state desired to be determined and when the target electrical equipment is not. Due to this, even when the electrical wiring line to be used for determination of the operating state of the target electrical equipment is unknown, it is possible to easily decide which electrical wiring line to use to be able to easily determine the operating state of the target electrical equipment.

The state determination device according to one aspect of the present disclosure may further include a minimum combination decision unit that compares combinations of energization states of the plurality of electrical wiring lines among the plurality of operating states in the target electrical equipment, and decides upon a minimum combination of the plurality of electrical wiring lines with which the plurality of operating states can be distinguished from one another.

According to the above configuration, it is possible to decide upon a minimum combination of the electrical wiring lines for determining the plurality of operating states of the target electrical equipment, that is, the combination of the electrical wiring lines to be measured.

In order to solve the above problem, a state determination system according to one aspect of the present disclosure includes: the state determination device; and a current sensor that is installed in each of a plurality of electrical wiring lines constituting target electrical equipment, the current sensor configured to transmit a signal indicating an energization state of the electrical wiring line based on a measured current value, in which the signal acquiring unit acquires the signal from the current sensor.

According to the above configuration, since a signal indicating the energization state of the electrical wiring line is transmitted, the energization state of the electrical wiring line can be transmitted to the state determination device with a small amount of information.

In order to solve the above problem, a state determination method according to one aspect of the present disclosure is a state determination method for determining a state of target electrical equipment, the state determination method including, signal acquisition of acquiring a signal corresponding to each of a plurality of electrical wiring lines constituting the target electrical equipment in association with each of the electrical wiring lines, the signal indicating an energization state of each of the electrical wiring lines; and state determination of determining an operating state of the target electrical equipment that can be distinguished by a combination of the energization states corresponding to the plurality of electrical wiring lines.

According to the above method, the above effect can be achieved.

The state determination device according to each aspect of the present disclosure may be implemented by a computer, and in this case, a control program of the state determination device that causes the computer to implement the state determination device by causing the computer to operate as each unit (software element) included in the state determination device, and a computer-readable recording medium recording the control program are also included in the scope of the present disclosure.

### Second Embodiment

### Overall Configuration of Second Embodiment

An embodiment of the present disclosure will be described in detail below.

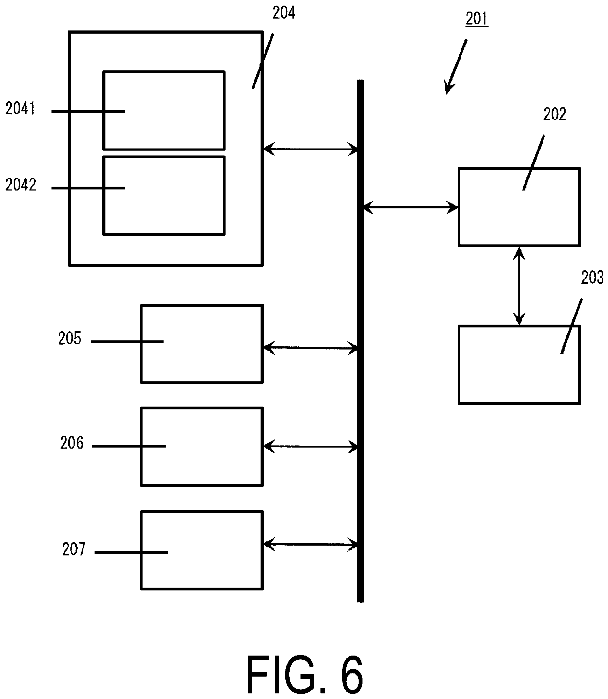

As illustrated in FIG. 6, a production system 201 according to the present disclosure includes a control device 202 that integrally controls the entire operation of the production system 201, and a storage device 203 that stores data necessary for control of the production system 201.

The control device 202 is communicably connected to each component of the production system 201, and can control the production system 201 according to a predetermined program. The control device 202 includes, for example, a computer device including an arithmetic processing unit such as a central processing unit (CPU) or a dedicated processor.

The storage device 203 can store various data or programs of each facility necessary for control of the production system 201, for example. The storage device 203 includes a random access memory (RAM) and a read only memory (ROM). In the present embodiment, for example, the storage device 203 stores various data related to the production system 201 in a nonvolatile manner. By reading and executing a program stored in the storage device 203, the control device 202 can create a manufacturing plan or the like. The storage device 203 also stores data required when the control device 202 causes a display 206 described later to display information of the production system 201.

The production system 201 further includes a scheduling device 204 that manages a manufacturing schedule, a measurement device 205 that measures an operating time of each manufacturing facility, and the display 206 that displays an operating status of the production system 201.

The scheduling device 204 can manage a manufacturing schedule of a product. The scheduling device 204 can create an efficient manufacturing plan from a required time (also referred to as scheduled operating time) of each facility used for manufacturing a product. As a result, the user of the production system 201 can be notified of a scheduled start time, a scheduled completion time, and the like of the product. It is possible to notify the user of which facility currently manufactures what.

The scheduling device 204 can modify the created manufacturing plan from past manufacturing results and the like. The scheduling device 204 can change the manufacturing plan by reflecting the desire of the user of the production system 201.

The scheduling device 204 includes an individual control device 2041 and an individual storage device 2042. The individual control device 2041 can integrally control the operation of the scheduling device 204. Specifically, the individual control device 2041 can create or modify a manufacturing plan based on a required time necessary for processing of each manufacturing facility according to a predetermined program, for example.

The individual storage device 2042 stores, for example, a required time for processing of each manufacturing facility, a program for creating a manufacturing plan, and the like. The individual storage device 2042 stores, for example, a required time for processing each manufactured product of each manufacturing facility, a facility code for identifying each manufacturing facility, and the like in a nonvolatile manner. The individual control device 2041 can create a manufacturing plan or the like by reading and executing a program stored in the individual storage device 2042.

In the present disclosure, other than the control device 202 and the storage device 203, the scheduling device 204 includes the individual control device 2041 and the individual storage device 2042, but the control device 202 and the storage device 203 may have the functions of the individual control device 2041 and the individual storage device 2042.

The measurement device 205 can measure the operating time of a facility. The measurement device 205 may be installed in each facility used for manufacturing a product. Specifically, the measurement device 205 may be a current sensor that detects ON/OFF of a sequencer or the like of each facility, a programmable logic controller (PLC), or the like. The measurement device 205 is not limited to the aforementioned, and is only required to be a device that can measure the operating time of the facility.

The measurement device 205 is communicably connected to the storage device 203 of the production system 201, and the measurement result of the operating time in the measurement device 205 is stored in the storage device 203 as an actual operating time. In other words, the storage device 203 stores a past actual operating time of each production facility.

The measurement device 205 may measure the operating time of the facility used for manufacturing a product based on the determination result of the state determination device 10100 or 10100'.

The display 206 can display the operating status of each manufacturing facility in the production system 201, for example. The display 206 is a display device that displays information, and is, for example, a liquid crystal display, a plasma display, an organic EL display, or the like. Display on the display 206 is controlled by the control device 202.

As described above, the control device 202 can control the display 206 so as to display the operating status of each manufacturing facility. The control device 202 can acquire the scheduled operating time of a facility from the individual storage device 2042 of the scheduling device 204, acquire an actual operating time of the facility from the storage device 203, and cause the display 206 to display the scheduled operating time and the actual operating time together. As a result, the user can grasp the processing ability of the facility.

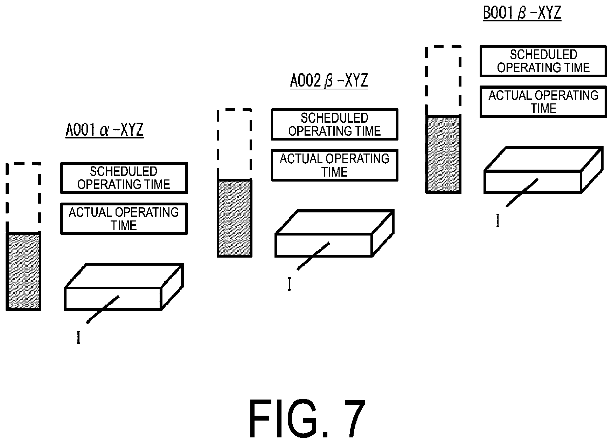

Specifically, in the present disclosure, as illustrated in FIG. 7, a mark I indicating the presence of a facility is displayed on the display 206, and the scheduled operating time and the actual operating time are displayed around the mark I. The mark I indicating the presence of the facility may be, for example, an icon.

The control device 202 may cause the display 206 to simultaneously display information of a plurality of facilities. As a result, the user can compare the processing abilities of the facilities at a glance. At this time, in the production system 201, when managing a plurality of facilities of the same type capable of executing same/similar processing, by causing the display 206 to display the plurality of facilities of the same type, the difference in ability among the facilities of the same type can be grasped.

The control device 202 may cause the display 206 to display information indicating the product being manufactured together with the scheduled operating time and the actual operating time. As a result, the user can know the product being processed as well as the processing ability of the facility. The information indicating the product is only required to be stored in the storage device 203. The information indicating the product may be, for example, a product name or a product code. In the present disclosure, a product code is illustrated, as illustrated in FIG. 7. In the present disclosure, "XYZ" in FIG. 7 is the product code.

The control device 202 may cause the display 206 to display the manufacturing progress rate in the facility based on the scheduled operating time and the actual operating time. As a result, the user can easily grasp the progress of manufacturing. Specifically, for example, by disposing a plurality of displays 206 in an office where the control device 202 is placed, a plant site where a production facility is placed, and the like, the production status can be grasped without directly going and checking the production facility, and, by the display 206, the progress of manufacturing can be grasped in both the office and the plant site.

The progress rate is only required to be displayed in a display form that changes in accordance with transition of the progress rate. The progress rate may be, for example, a numerical value indicated by a percentage, or may be a gauge indicating the progress. In the present disclosure, as illustrated in FIG. 7, a bar graph is adopted as a type of gauge.

When the actual operating time exceeds the scheduled operating time, the control device 202 may cause the display 206 to highlight a specific region so as to notify that fact. As a result, the user can easily grasp that the manufacturing is behind schedule. It does not matter how the highlight display is performed as long as the information of the fact that the actual operating time exceeds the scheduled operating time is displayed more conspicuously than other information. For example, the color of the actual operating time may be changed, the mark I may be made to blink, or the luminance of the gauge may be changed. In the present disclosure, the color of the bar graph is controlled to be changed.

The production system 201 may include a notification device 207 that notifies the user of the production system 201 of the status of the facility. Then, when the actual operating time exceeds the scheduled operating time and moreover the actual operating time exceeds a predetermined time, the control device 202 may cause the notification device 207 to notify the user of the fact. As a result, the user can easily grasp that the manufacturing is too far behind schedule, and in some cases, the user can quickly notice an abnormality in the facility. The predetermined time can be discretionally set by the user, and may be set to a time at which the progress rate is 70% to 80%, for example.

The notification means of the notification device 207 is not particularly limited as long as it can notify the user. For example, the notification device 207 may notify the user by means such as sound or light. In this case, the notification device 207 is only required to be, for example, an alarm, a signal display lamp, or the like. The notification device 207 may contact a personal computer (PC) or a mobile phone or the like owned by the user via a communication device.

As described above, when the actual operating time exceeds the scheduled operating time and the actual operating time exceeds the predetermined time, the control device 202 may determine that the facility is unusable and cause the scheduling device 204 to change the schedule. As a result, a delay in schedule can be reduced.

When the actual operating time gets close to the scheduled operating time, the control device 202 may cause the notification device 207 to provide notification of the fact. As a result, the user can move on to preparation for the next step.

The control device 202 may calculate a time difference between the scheduled operating time and the actual operating time (hereinafter, also simply referred to as "time difference") and store a calculation result in the storage device 203. As a result, the processing ability of the facility can be stored as a log. This calculation result may be expressed as a percentage or a relative value calculated as a result of subtraction. The display form of this calculation result is discretionally selected by the user.

The control device 202 may change the scheduled operating time stored in the storage device 203 (individual storage device 2042) based on the time difference. The scheduling device 204 may manage the manufacturing plan (schedule) based on the scheduled operating time after being changed. As a result, the scheduling device 204 can optimize the manufacturing plan according to the true processing ability of the facility. The control device 202 may control the scheduling device 204 so as to increase the scheduled operating time to lower the operating rate of the facility, or may control the scheduling device 204 so as to shorten the scheduled operating time to increase the operating rate of the facility.

The control device 202 may cause the storage device 203 to store data of a plurality of time differences from past to present, and when an average value of the plurality of time differences exceeds a predetermined threshold, may change the scheduled operating time of the storage device 203. As a result, it is possible to reduce the likelihood of the scheduling device 204 changing the manufacturing plan in a case where the time difference temporarily increases due to an unexpected situation. That is, unnecessary changes in manufacturing plans can be reduced. The predetermined threshold is only required to be discretionally set by the user. In the present disclosure, for example, the predetermined threshold is set to 30 minutes.

The control device 202 may cause the storage device 203 to store the facility code related to the manufacturing facility and cause the display 206 to display the facility code together with the scheduled operating time and the actual operating time. As a result, in a plant or the like having an infinite number of manufacturing facilities, the user can easily grasp the operating status of each facility. The facility code is only required to be discretionally set by the user, and may be, for example, a facility name or may be a symbol stored in association with the facility name. In the present disclosure, as illustrated in FIG. 7, the facility code includes an alphabet and a number.

When managing a plurality of facilities capable of processing the same step, the control device 202 may cause the storage device to store a facility code having a common code common to the plurality of facilities and an individual code unique to each of the plurality of facilities. The control device 202 may cause the display 206 to display the common code and the individual codes. As a result, the user can compare, on the display 206, facilities of the same types. The common code and the individual codes are only required to be discretionally set by the user. In the present disclosure, as illustrated in FIG. 7, the common code is indicated by an alphabet, and the individual codes are each indicated by a number.

The facility code stored in the storage device 203 may include an owner code indicating an owner of the facility. Then, the control device 202 may cause the display 206 to display the owner code. As a result, when the user cannot use his/her own facility due to trouble or the like, the user can ask another user to lend their facility. The owner code is only required to be discretionally set by the user. In the present disclosure, as illustrated in FIG. 7, the owner code is written in the Greek alphabet.

If there is a certain time difference when comparing the actual operating times of the plurality of facilities, the control device 202 may notify the user of that fact via the notification device 207. As a result, the processing abilities of the facilities that perform the same processing of the same product can be grasped, for example.

The present disclosure is not limited to each of the embodiments described above, and various modifications can be made within the scope indicated by the claims, and an embodiment obtained by appropriately combining technical means disclosed in different embodiments is also included in a technical scope of the present disclosure. New technical features can be formed by combining the technical means disclosed in each embodiment.

For example, the production system 201 may include an input device that allows the user to input new information. The input device is, for example, a keyboard, a mouse, or the like. The display 206 and the input device may be integrated as a touchscreen or the like.

The input device may also receive an instruction related to scheduling, for example, changing the priority of a manufactured product, changing the delivery date, or the like, and notify the scheduling device of the content.

### Supplementary Note

The present disclosure can be expressed as follows.

### First Aspect

A production system according to the present disclosure includes: a storage device configured to store scheduled operating times of a plurality of facilities used for manufacturing of a product; a measurement device configured to measure operating times of the facilities used for manufacturing of the product; a display configured to display progress of manufacturing of the product; and a control device configured to control display on the display, in which the control device acquires scheduled operating times of the plurality of facilities from the storage device, acquires actual operating times of the plurality of facilities from the measurement device, and causes the display to display the scheduled operating time and the actual operating time based on the acquired scheduled operating time and actual operating time.

### Second Aspect

A production system according to the present disclosure is the production system according to the first aspect, in which the control device causes the display to display a progress rate of manufacturing in the facility based on the scheduled operating time and the actual operating time.

### Third Aspect

A production system according to the present disclosure is the production system according to the first or second aspect, in which the control device causes the display to express the progress rate in a display form that changes in accordance with transition of the progress rate.

### Fourth Aspect

A production system according to the present disclosure is the production system according to any of the first to third aspects, in which the control device, when the actual operating time exceeds the scheduled operating time, highlights that fact on the display to provide notification of the fact.

### Fifth Aspect

A production system according to the present disclosure is the production system according to any of the first to fourth aspects further including a notification device configured to notify a user, in which the control device, when the actual operating time exceeds the scheduled operating time and the actual operating time exceeds a predetermined time, causes the notification device to notify the user of that fact.

### Sixth Aspect

A production system according to the present disclosure is the production system according to any of the first to fifth aspects, in which the control device causes the storage device to store a time difference between the scheduled operating time and the actual operating time.

### Seventh Aspect

A production system according to the present disclosure is the production system according to the sixth aspect further including a scheduling device configured to manage a schedule of manufacturing of a product, in which the control device changes the scheduled operating time of the storage device based on the time difference between the scheduled operating time and the actual operating time, and causes the scheduling device to manage the schedule based on the scheduled operating time after being changed.

### Eighth Aspect

A production system according to the present disclosure is the production system according to the seventh aspect, in which the control device causes the storage device to store a plurality of time differences between scheduled operating times and actual operating times from past to present, and to change the scheduled operating time of the storage device when an average value of the plurality of time differences between the scheduled operating times and the actual operating times exceeds a predetermined threshold.

### Ninth Aspect

A production system according to the present disclosure is the production system according to any of the first to eighth aspects, in which the storage device stores a facility code related to the facility, and the control device causes the display to display the facility code in association with the scheduled operating time and the actual operating time.

### Tenth Aspect

A production system according to the present disclosure is the production system according to any of the first to ninth aspects, in which, when managing a plurality of facilities capable of processing the same step, the storage device stores a facility code having a common code common to the plurality of facilities and an individual code unique to each of the plurality of facilities.

### Eleventh Aspect

A production system according to the present disclosure is the production system according to the ninth or tenth aspect, in which the facility code has an owner code indicating an owner of the facility.

### Twelfth Aspect

A production system according to the present disclosure is the production system according to the tenth or eleventh aspect, in which the control device notifies a user when comparison of actual operating times of each of the plurality of facilities shows a certain time difference.

### Third Embodiment

### Overall Outline of Third Embodiment

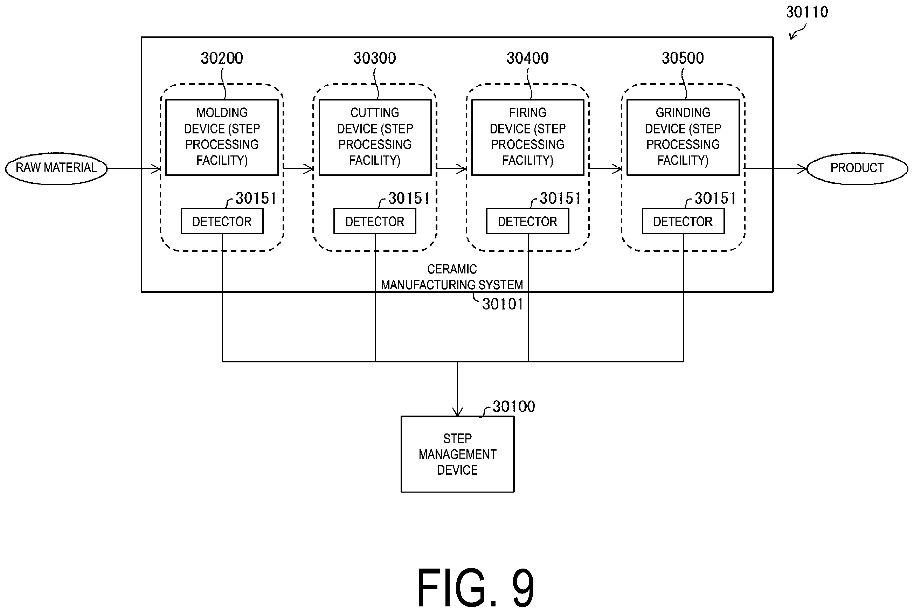

An embodiment of the present disclosure will be described in detail below. First, a step management system 30110 according to the present embodiment will be described with reference to FIG. 9. FIG. 9 is a view illustrating an overall outline of the step management system 30110. In the present embodiment, as a target to be managed by a step management device 30100, a facility related to manufacturing of a ceramic will be described as an example, but the present invention is not limited to this. Any manufacturing facility including a processing step may be a target, and the facility may be various manufacturing plants for machinery or the like, food plants, printing and paper plants, petrochemical plants, or the like.

As illustrated in FIG. 9, the step management system 30110 according to the present embodiment includes a ceramic manufacturing system 30101 and the step management device 30100.

In the step management system 30110 according to the present embodiment, the ceramic manufacturing system 30101 automatically acquires start and completion of processing for each step, and the step management device 30100 decides upon the start time and the completion time in each facility. Since the start time and the completion time can be automatically decided, it is possible to appropriately and promptly judge whether the manufacturing processing is proceeding according to the manufacturing schedule.

### Ceramic Manufacturing System

As illustrated in FIG. 9, the ceramic manufacturing system 30101 includes one or a plurality of molding devices 30200, cutting devices 30300, firing devices 30400, and grinding devices 30500 that are used for processing of each step for manufacturing a ceramic. Hereinafter, the facilities (molding device 30200, cutting device 30300, firing device 30400, and grinding device 30500) included in the ceramic manufacturing system 30101 are collectively referred to as step processing facility X.

Then, in the ceramic manufacturing system 30101, a ceramic product is manufactured through the following steps. First, there is a raw material of a ceramic, and the raw material of the ceramic is molded by the molding device 30200 to form a ceramic molded body. Next, the ceramic molded body is cut by the cutting device 30300, the ceramic molded body after cutting is fired by the firing device 30400, and a ceramic fired body after firing is ground by the grinding device 30500 to manufacture a ceramic product.

### Step Management Device

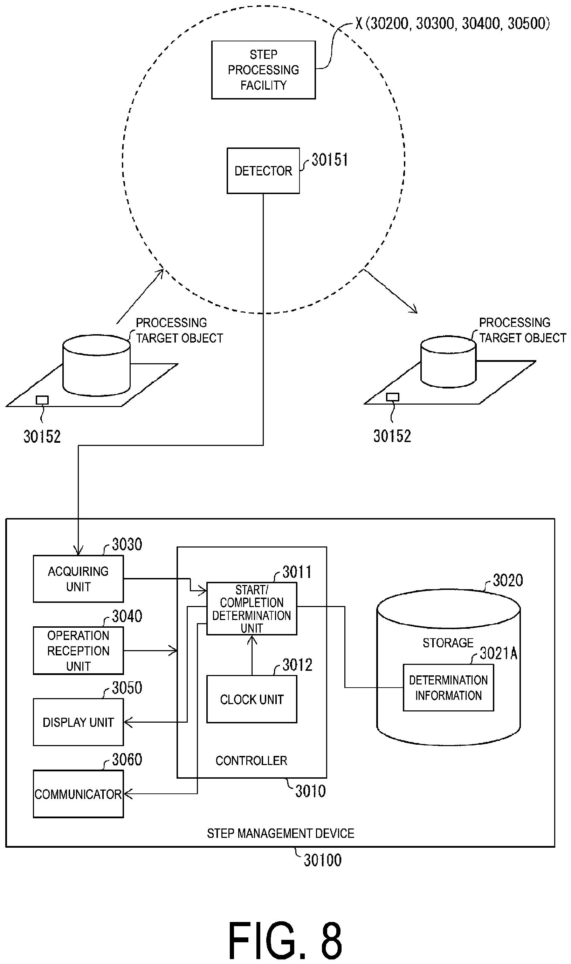

Next, the step management device 30100 will be described with reference to FIG. 8. FIG. 8 is a block diagram illustrating the configuration of the main part of the step management device 30100.

As illustrated in FIG. 8, the step management device 30100 includes a controller 3010, a storage 3020, an acquiring unit 3030, an operation reception unit 3040, a display unit 3050, and a communicator 3060.

The controller 3010 executes processing in the step management device 30100, and includes a start/completion determination unit (start determination unit and completion determination unit) 3011 and a clock unit 3012.

The start/completion determination unit 3011 determines start and completion of the processing step using the step processing facility X in the ceramic manufacturing system 30101, and decides upon a start time and completion time that are the times of start and completion, respectively, with reference to the clock unit 3012.

This will be described more specifically. In the present embodiment, a detector 30151 is provided near the step processing facility X. The detector 30151 detects whether a detection target exists in a predetermined range from the step processing facility X, and is, for example, a radio frequency identification (RFID) reading unit. In the present embodiment, a tag (wireless communication tag) 30152 is attached to a table on which a ceramic product that is the processing target object is placed, and when the tag 30152 enters the detection range of the detector 30151, whether the processing target object has entered the predetermined range from the step processing facility X or whether the processing target object has exited the predetermined range can be detected. When the detector 30151 is an RFID reading unit, the tag 30152 is an RFID tag.

The detector 30151 detects the presence or absence of the detection target (tag) in the predetermined range at a predetermined cycle, and transmits a detection result to the step management device 30100. The predetermined cycle may be, for example, several seconds. The predetermined range may have a radius of several meters, for example.

Upon acquiring a signal indicating that the tag 30152 is detected from the detector 30151 via the acquiring unit 3030, the start/completion determination unit 3011 judges that the processing target object has entered the predetermined range of the step processing facility X, decides that the step has been started at that time point or at a time point after a predetermined time has elapsed from that time point, and with reference to the clock unit 3012, decides upon, as a start time, the time point at which the step is decided to have been started. With reference to determination information 3021A, the start/completion determination unit 3011 also determines which product of which step has been started.

Upon acquiring a signal indicating that the tag 30152 detected by the detector 30151 is no longer detected, the start/completion determination unit 3011 judges that the processing target object has exited the predetermined range of the step processing facility X, decides that the step has been completed at that time point or a time point a predetermined time before that time point, and with reference to the clock unit 3012, decides upon, as completion time, the time point at which the step is decided to have been completed.

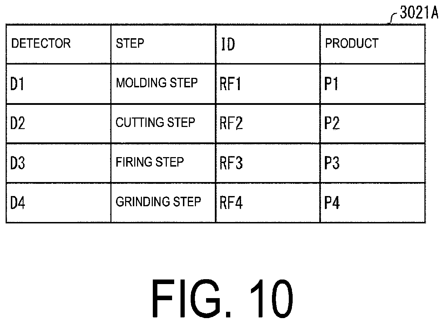

Here, the determination information 3021A will be described with reference to FIG. 10. FIG. 10 is a view illustrating an example of the determination information 3021A. The determination information 3021A is information used by the start/completion determination unit 3011 to determine whether the step is started or completed, and is associated with information for identifying the detector 30151, step content, an ID for identifying the tag 30152, and the product. In the example illustrated in FIG. 10, "D1", "molding step", "RF1", and "P1" are associated as the information for identifying the detector 30151, the step content, the ID for identifying the tag 30152, and the product, respectively. If detection is made in the detector 30151 "D1", the step is the "molding step", and if the detected tag 30152 is "RF1", the product that is the processing target object is "P1". The same applies hereinafter. The correspondence relationship between the detector 30151 and the processing step and the correspondence relationship between the tag 30152 and the product are set in advance.

The acquiring unit 3030 acquires a signal indicating a detection result from the detector 30151 provided near the step processing facility X of the ceramic manufacturing system 30101, and transmits the signal to the start/completion determination unit 3011.

The operation reception unit 3040 receives user operation on the step management device 30100, and is, for example, a keyboard, a mouse, or the like. The display unit 3050 and the operation reception unit 3040 may be integrated as a touchscreen or the like.

The display unit 3050 is a display device that displays information, and is, for example, a liquid crystal display, a plasma display, an organic EL display, or the like.

The communicator 3060 communicates with external equipment, and transmits a determination result of the start/completion determination unit 3011 to the external equipment, for example.

As described above, the step management device 30100 according to the present embodiment includes the detector 30151 configured to detect that a processing target object has entered a predetermined range near a facility where a step is performed, and the start/completion determination unit 3011 configured to set, as a start time, the time at which the detector 30151 detects that the processing target object has entered the predetermined range or a time after a lapse of a predetermined time from the time. The detector 30151 may detect that the processing target object has exited the predetermined range, and the start/completion determination unit 3011 may set, as the completion time, a time at which the detector 30151 detects that the processing target object has exited the predetermined range or a time a predetermined time before the time.

Furthermore, the processing target object may be a ceramic molded body or a ceramic fired body, and the detector 30151 may detect that the processing target object is in the predetermined range by detecting a wireless communication tag attached to a holder holding one or a plurality of the ceramic molded bodies or ceramic fired bodies.

The detector 30151 may be included in the step management device 30100 or need not be included in the step management device 30100. That is, the step management device 30100 may be referred to with the detector 30151 included.

### Flow of Processing

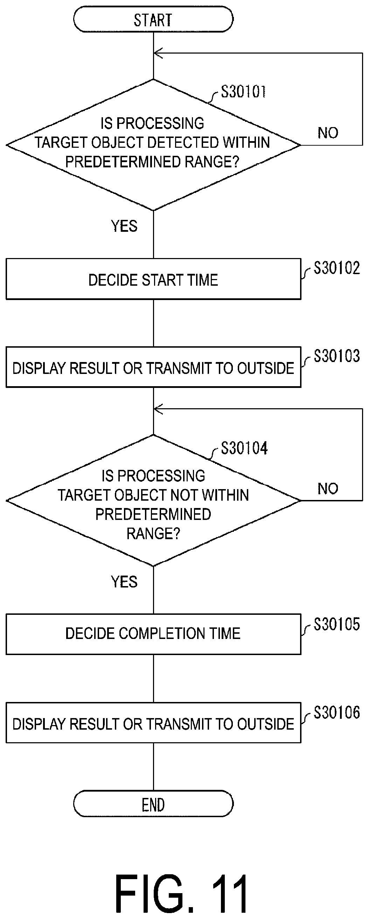

Next, the flow of processing in the step management device 30100 will be described with reference to FIG. 11. FIG. 11 is a flowchart showing the flow of processing in the step management device 30100.

As shown in FIG. 11, in the step management device 30100, upon acquiring a signal indicating that the detector 30151 has detected the tag 30152 (YES in S30101), the start/completion determination unit 3011 determines that the step has been started and decides upon the start time (S30102). Then, information indicating the content of the step that has been started and the target product (processing target object) is displayed on the display unit 3050 or transmitted to the outside via the communicator 3060 (S30103). Both display and transmission to the outside may be performed.

Next, in the step management device 30100, upon acquiring a signal indicating that the tag 30152 detected by the detector 30151 is no longer detected (YES in S30104), the start/completion determination unit 3011 determines that the step has been completed and decides upon the completion time (S30105). Then, information indicating the content of the step that has been completed and the target product (processing target object) is displayed on the display unit 3050 or transmitted to the outside via the communicator 3060 (S30106). As with the start, both display and transmission to the outside may be performed for completion.

### Variation

In the above-described embodiment, start and completion are judged based on whether the tag 30152 is detected by the detector 30151 provided near the step processing facility X, that is, whether the processing target object has entered the predetermined range from the step processing facility X.

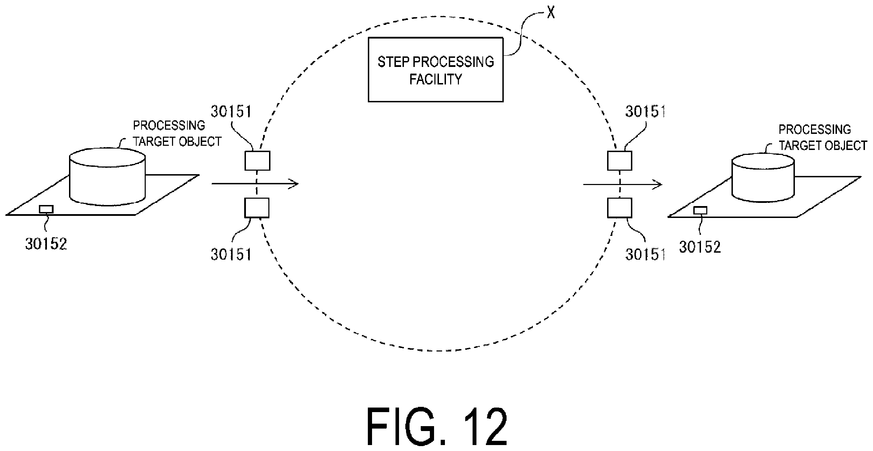

The configuration of the detector 30151 is not limited to this. For example, if it is necessary to pass through a certain point in order to perform processing by the step processing facility X, the detector 30151 may be provided at the certain point, and it may be determined whether the tag 30152 has been detected based on whether the tag 30152 has passed through the detector 30151 (see FIG. 12).

The detector 30151 may be installed at one point, namely, the entrance or at two points, namely, the entrance and the exit.

### Third Embodiment 2

Another embodiment of the present disclosure will be described below. Note that, for convenience of description, a member having the same function as that of a member described in the embodiments described above is denoted by the same reference sign, and description thereof will not be repeated.

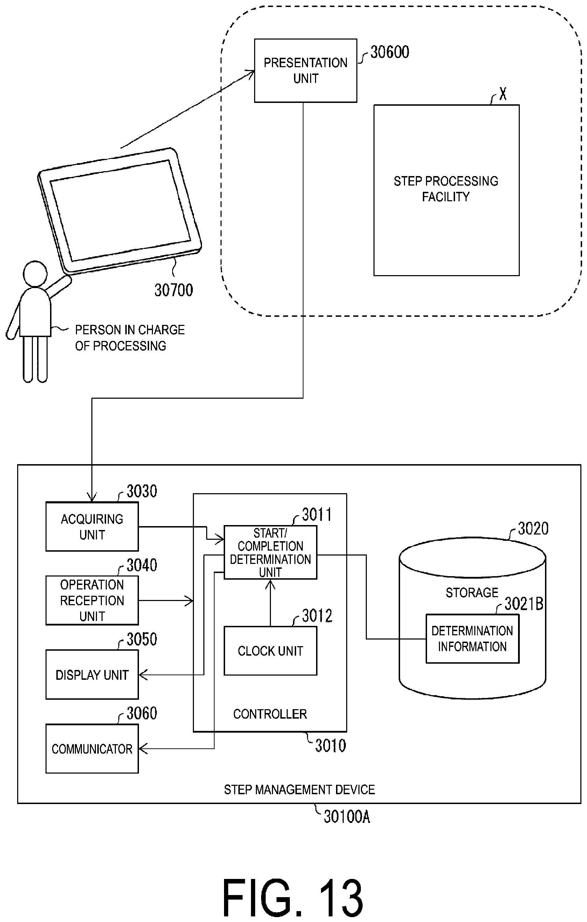

FIG. 13 is a block diagram illustrating an example of a presentation unit 30600 according to the present embodiment and the configuration of a main part of a step management device 30100A.

As illustrated in FIG. 13, in the present embodiment, the presentation unit 30600 is provided near the step processing facility X, and it is assumed that the person in charge of processing performs processing by confirming the content presented on the presentation unit 30600. A person-in-charge terminal (communication terminal) 30700 used by the person in charge of processing and the presentation unit 30600 can communicate with each other by short-range wireless communication, and before the processing in the step processing facility X starts, the person-in-charge terminal 30700 gives the presentation unit 30600 presentation instructions for a work instruction document indicating the work content of the step, a drawing, product information, a lot number, and the like.

Upon completing the step in the step processing facility X, the person-in-charge terminal 30700 may give the presentation unit 30600 a confirmation presentation instruction to present the presentation unit 30600 a work end confirmation document that needs to be confirmed at the time of completion, the work end confirmation document including items to be confirmed by the person in charge of processing at the time of completion.

The acquiring unit 3030 according to the present embodiment acquires a signal indicating that the presentation instruction (active action of worker, for example, call input of work instruction document) has been received from the presentation unit 30600 or a signal indicating that the worker has browsed the work instruction document, and notifies the start/completion determination unit 3011. As for whether the worker has browsed the work instruction document, for example, it may be detected that a page of the work instruction document has been turned, or a sensor (browsing detector) detecting a line of sight of the worker that is provided in the presentation unit 30600 may detect that the worker has browsed the work instruction document presented in the presentation unit 30600.

Upon acquiring, via the acquiring unit 3030, a signal indicating that the presentation unit 30600 has received or browsed the presentation instruction, the start/completion determination unit 3011 decides that the step has been started at that time point or a time point after a predetermined time has elapsed from that time point, and with reference to the clock unit 3012, decides upon, as the start time, the time point at which the step is decided to have been started. With reference to determination information 3021B, the start/completion determination unit 3011 also determines which step has been started.

Upon acquiring, via the acquiring unit 3030, a signal indicating that the presentation unit 30600 has received or browsed the confirmation presentation instruction, the start/completion determination unit 3011 decides that the step has been completed at that time point or a time point after a predetermined time has elapsed from that time point, and with reference to the clock unit 3012, decides upon, as the completion time, the time point at which the step is decided to have been completed.

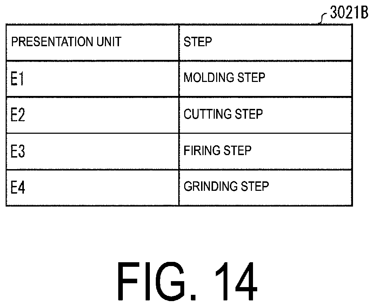

Here, the determination information 3021B will be described with reference to FIG. 14. FIG. 14 is a view illustrating an example of the determination information 3021B. The determination information 3021B is information used by the start/completion determination unit 3011 to determine whether the step is started or completed, and is associated with information for identifying the presentation unit 30600 and step content. In the example illustrated in FIG. 14, "E1" and "molding step" are associated as information for identifying the presentation unit 30600 and the step content, respectively. If the presentation unit 30600 "E1" receives a presentation instruction, the step is the "molding step". The same applies hereinafter. The correspondence relationship between the presentation unit 30600 and the processing step is set in advance.

As described above, the step management device 30100A according to the present embodiment includes the start/completion determination unit 3011 that sets, as a start time, the time point at which the person in charge of the step to be performed inputs an instruction to the presentation unit 30600, which is installed in a predetermined region near a facility where the step is performed and which is capable of communicating by short-range wireless communication via the person-in-charge terminal 30700 used by the person in charge, instructing the presentation of the work instruction document related to the work content of the step by short-range wireless communication, or the time point at which a signal indicating the browsing is acquired from the browsing detector that detects that the person in charge of the step to be performed has browsed the work instruction document.

### Variation 1

In the present embodiment, a detector 30155 may be further provided near the step processing facility X.

The detector 30155 detects whether the person in charge of processing has entered a predetermined range of the step processing facility X. Methods for the detector 30155 to detect the person in charge of processing may be detection using a human sensor (infrared sensor), detection by reading an ID card or a mobile communication terminal of the person in charge of processing, or detection by a beacon or the like.

Upon acquiring a signal indicating that a presentation instruction was given within a predetermined time from when the detector 30151 detected the person in charge of processing entered the predetermined range of the step processing facility X or that the work instruction document was browsed, the start/completion determination unit 3011 decides upon, as the start time, the time at which the step stops.

### Variation 2

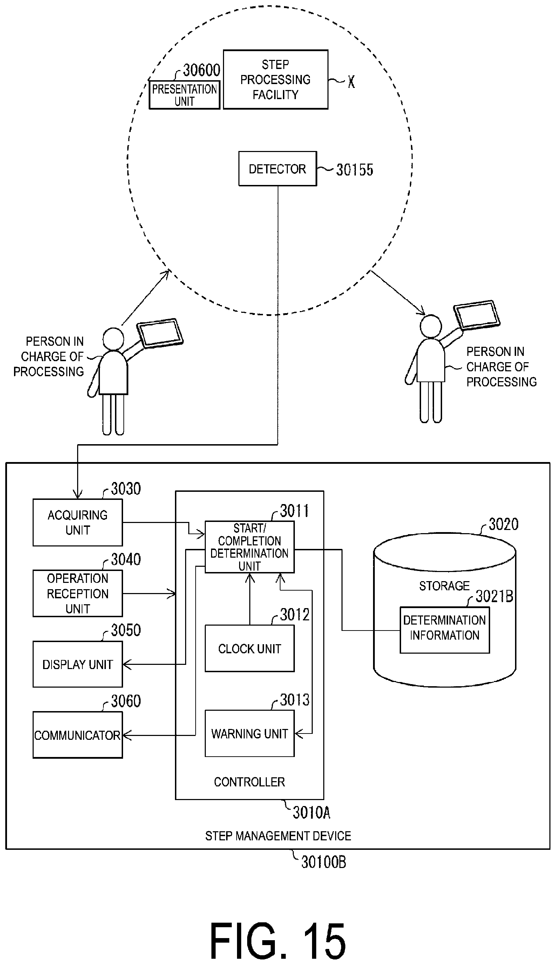

FIG. 15 illustrates a variation of the present embodiment. As illustrated in FIG. 15, in the present variation, a warning unit 3013 is included in a controller 3010A of a step management device 30100B. The warning unit 3013 issues a warning via the display unit 3050 when the detector 30151 does not acquire a signal indicating a presentation instruction or a presentation confirmation within a predetermined time after detecting that the person in charge of processing has entered the predetermined range of the step processing facility X. Other than the display unit 3050, a sound output unit or the like may be provided and a warning may be issued via the sound output unit.

Upon acquiring a signal indicating that the presentation instruction has been given or the work instruction document has been browsed after the warning by the warning unit 3013, the start/completion determination unit 3011 may decide upon, as the start time, the time at which the person in charge of processing enters the predetermined range of the step processing facility X or a time after a predetermined time has elapsed from the time.

### Variation 3

When the step management device 30100 can acquire the state of the step processing facility X and the step processing facility X executing the processing enters a processing startable state after the presentation instruction is given to the presentation unit 30600, the start/completion determination unit 3011 may determine that the step has started and decide upon the start time.

### Third Embodiment 3

Another embodiment of the present disclosure will be described below. Note that, for convenience of description, a member having the same function as that of a member described in the embodiments described above is denoted by the same reference sign, and description thereof will not be repeated.

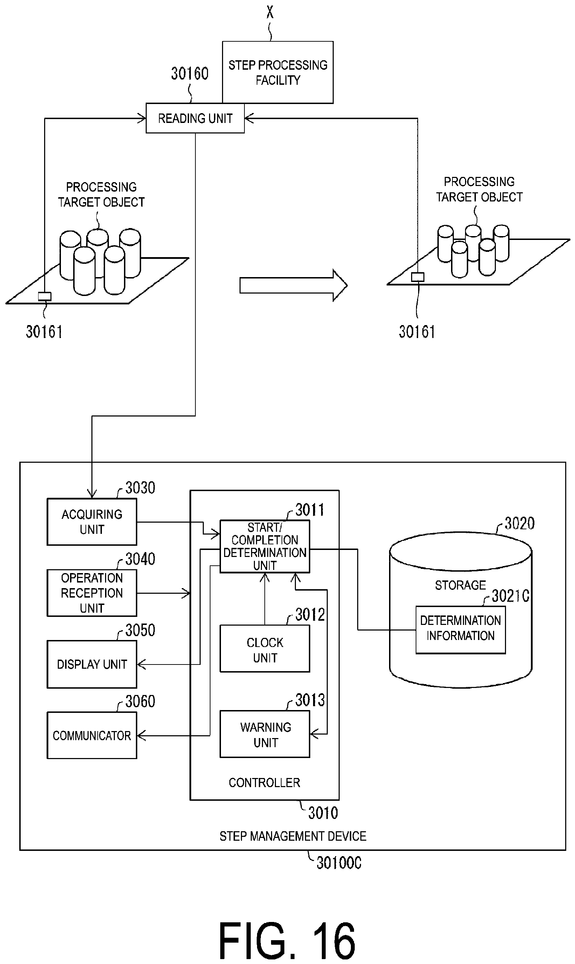

FIG. 16 is a block diagram illustrating an example of a reading unit 30160 according to the present embodiment and the configuration of a main part of a step management device 30100C. In the present embodiment, it is assumed that one or a plurality of processing target objects are held by holders and transported to the step processing facility X where processing is performed. In the present embodiment, the holder is marked with correspondence information (for example, barcode) associated with the holder, and as illustrated in FIG. 16, the reading unit (reading machine) 30160 for reading the correspondence information is provided near the step processing facility X.

Then, as the correspondence information is read by the reading unit 30160, a work instruction document indicating the work content of the step, a drawing, product information, a lot number, and the like are presented to the presentation unit 30600.

As illustrated in FIG. 16, the step management device 30100C according to the present embodiment stores determination information 3021C in the storage 3020.

Then, upon acquiring a signal indicating that the reading unit 30160 has read the correspondence information via the acquiring unit 3030, the start/completion determination unit 3011 decides that the step has been started at the time point or at a time point after a predetermined time has elapsed from the time point, and with reference to the clock unit 3012, decides upon, as the start time, the time point at which the step is decided to have been started. With reference to the determination information 3021C, the start/completion determination unit 3011 also determines which step has been started.

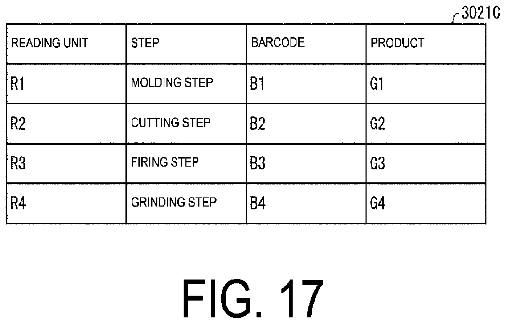

Here, the determination information 3021C will be described with reference to FIG. 17. FIG. 17 is a view illustrating an example of the determination information 3021C. The determination information 3021C is information used by the start/completion determination unit 3011 to determine whether the step is started or completed, and is associated with information for identifying the reading unit 30160, step content, a barcode (correspondence information), and the product. In the example illustrated in FIG. 17, "R1", "molding step", "B1", and "G1" are associated as the information for identifying the reading unit 30160, the step content, the barcode, and the product, respectively. If reading is performed at the reading unit 30160 "R1", the step is the "molding step", and if the read barcode is "B1", the product that is a processing target object is "G1". The same applies hereinafter. The correspondence relationship between the reading unit 30160 and the processing step and the correspondence relationship between the barcode and the product are set in advance.

As described above, in the step management device 30100C according to the present embodiment, a holder holding one or a plurality of processing target objects is attached with correspondence information associated with the holder, and the correspondence information is conveyed integrally with the holder and can be read by the reading unit 30160 provided in a predetermined region near the facility where the step is performed, the step management device 30100C including the start/completion determination unit 3011 that, by reading the correspondence information by the reading unit 30160 corresponding to the step before the step, sets, as a start time, a time at which an instruction to present the presentation unit 30600 installed in the predetermined region with a work instruction document indicating work content of the step is issued.

The step management device 30100C includes the detector 30155 configured to detect that a person in charge of a step that is a target to be performed has entered a predetermined range near a facility where the step is performed, and includes the warning unit 3013 that issues a warning when the reading is not performed within a predetermined time after the detector 30155 detects that the person in charge has entered the predetermined range, and when the reading is performed after the warning, the start/completion determination unit 3011 sets, as a start time, a time at which the person in charge entered the predetermined range or a time after a lapse of a predetermined time from the time.

### Variation 4

All the embodiments described above may include a delay notification transmission unit that transmits delay notification to an external management device when the completion time decided by the start/completion determination unit 3011 is behind a predetermined schedule. As a result, when the completion time is behind the schedule, it is possible to notify so.

### Variation 5

When the processing step that is a target to be determined requires measurement processing of a processing target object at an end of the step, the start/completion determination unit 3011 may set, as a completion time, a time after a predetermined time elapses after a measurement machine used for the measurement processing is removed from a predetermined storage position or a time at which the measurement machine is returned to the storage position.

This can be implemented, for example, by providing a sensor that detects that the measurement machine is taken out from the storage place and acquiring a detection result by the sensor in the start/completion determination unit 3011.

### Variation 6

The step management device 30100, 30100A, 30100B, or 30100C may cause the display 206 included in the production system 201 to display a start time.

### Example of Software Implementation

A control block (in particular, the controller 3010 (3010A or 3010B)) of the step management device 30100 (30100A, 30100B, or 30100C) may be implemented by a logic circuit (hardware) formed in an integrated circuit (IC chip) or the like, or may be implemented by software.

In the latter case, the step management device 30100 includes a computer that executes a command of a program that is software for implementing each function. This computer includes, for example, at least one processor (control device) and at least one computer-readable recording medium storing the program. Then, in the computer, the processor reads the above program from the recording medium and executes the read program to achieve the object of the present disclosure. As the processor, a central processing unit (CPU) can be used, for example. As the recording medium, a "non-transitory tangible medium" such as, for example, a read only memory (ROM), a tape, a disk, a card, a semiconductor memory, a programmable logic circuit, and the like can be used. Additionally, a random access memory (RAM) for loading the above program may be further provided. The above program may be supplied to the computer via any transmission medium (communication network, broadcast wave, and the like) capable of transmitting the program. Further, one aspect of the present disclosure may be implemented in the form of data signals embedded in a carrier wave in which the above program is embodied by electronic transmission.

### Supplementary Note

The present disclosure can be expressed as follows.

A step management device according to one aspect of the present disclosure includes: a detector configured to detect that a processing target object has entered a predetermined range near a facility where a step is performed; and a start determination unit configured to set, as a start time, a time at which the detector detects that the processing target object has entered the predetermined range or a time after a lapse of a predetermined time from the time.

According to the above configuration, since the start time can be decided without manually input processing by a person in charge of processing of a step or the like, situation where the start time cannot be decided due to input omission or the like can be avoided. By automatically deciding upon the start time, the progress of the manufacturing step can be appropriately checked.

In the step management device according to one aspect of the present disclosure, the detector may detect that the processing target object has exited the predetermined range, and the step management device may include a completion determination unit that sets, as a completion time, a time at which the detector detects that the processing target object has exited the predetermined range or a time a predetermined time before the time.

According to the above configuration, since the completion time can be decided without manually input processing by a person in charge of processing of a step or the like, a situation where the completion time cannot be decided due to input omission or the like can be avoided.

In a step management device according to one aspect of the present disclosure, the processing target object may be a ceramic molded body or a ceramic fired body, and the detector may detect that the processing target object is in the predetermined range by detecting a wireless communication tag attached to a holder holding one or a plurality of the ceramic molded bodies or ceramic fired bodies.

The ceramic molded body or the ceramic fired body cannot have a member or the like directly attached thereto for detection. According to the above configuration, since the wireless communication tag is attached to the holder holding the ceramic molded body or the ceramic fired body, it is possible to appropriately detect whether the ceramic molded body or the ceramic fired body that cannot have a member or the like directly attached thereto has entered a predetermined range.

A step management device according to one aspect of the present disclosure may include a start determination unit that sets, as a start time, a time at which a person in charge of a step that is a target to be performed inputs an instruction to present work instruction document related to work of the step by short-range wireless communication to a presentation unit installed in a predetermined region near the facility where the step is performed, the presentation unit being capable of communicating by short-range wireless communication via a communication terminal used by the person in charge.

According to the above configuration, since the time at which there is input for presenting the work instruction document that is essential for performing work is set as a start time, the start time can be reliably decided.

A step management device according to one aspect of the present disclosure may include a start determination unit that sets, as a start time, a time at which a facility is in a processing startable state after a person in charge of a step to be performed inputs an instruction to present a work instruction document related to work content of the step by short-range wireless communication to a presentation unit installed in a predetermined region near the facility where the step is performed, the presentation unit being capable of communicating by short-range wireless communication via a communication terminal used by the person in charge.

According to the above configuration, since there is input for presenting a work instruction document that is essential for performing work, and the time at which the facility is in the processing startable state is set as a start time, the start time can be reliably decided.

A step management device according to one aspect of the present disclosure may include a start determination unit that sets, as a start time, the time point when a signal indicating browsing is acquired from a browsing detector that detects that a person in charge of a step to be performed has browsed a work instruction document related to work content of the step presented in the presentation unit installed in a predetermined region near a facility where the step to be performed is performed.

According to the above configuration, since the time at which the work instruction document necessary for performing the work is browsed is set as a start time, the start time can be reliably decided.

A step management device according to one aspect of the present disclosure may include a detector configured to detect that the person in charge has entered a predetermined range near a facility where a step is performed, and when the instruction input is performed within a predetermined time from a time at which the detector detects that the person in charge has entered the predetermined range, the start determination unit may set, as a start time, a time at which the instruction input is performed.

According to the above configuration, since the start time is decided when the person in charge of the step is reliably present at the place where the step is executed, the accuracy of decision of the start time can be enhanced.

A step management device according to one aspect of the present disclosure may include a warning unit configured to issue a warning when the instruction input is not performed within a predetermined time after the detector detects that the person in charge has entered the predetermined range, and when the instruction input is performed after the warning, the start determination unit sets, as a start time, a time at which the person in charge entered the predetermined range or a time after a lapse of a predetermined time from the time.

According to the above configuration, even when the person in charge forgets to present the work instruction document, the start time can be decided by warning the person in charge.

A step management device according to one aspect of the present disclosure may include a completion determination unit that sets, as a completion time, a time at which a person in charge of a step to be performed inputs an instruction to present work end confirmation that needs to be confirmed at the work end time of the step, by short-range wireless communication to a presentation unit installed in a predetermined region near the facility where the step is performed, the presentation unit being capable of communicating by short-range wireless communication via a communication terminal used by the person in charge, or a time after a lapse of a predetermined time from the time.

According to the above configuration, since the time at which there is input for presenting the work end confirmation document that requires confirmation at the time of ending the work or a time after a lapse of a predetermined time from the time is set as completion time, the completion time can be reliably decided.

A step management device according to one aspect of the present disclosure may include a completion determination unit that sets, as a completion time, the time point or a time after a lapse of a predetermined time from the time point when a signal indicating browsing is acquired from a browsing detector that detects that a person in charge of a step to be performed has browsed a work end confirmation document that needs to be confirmed at work end of the step presented in the presentation unit installed in a predetermined region near a facility where the step to be performed is performed.

According to the above configuration, since the time at which the work end confirmation document that requires confirmation at the time of ending the work is browsed or a time after a lapse of a predetermined time from the time point is set as a completion time, the completion time can be reliably decided.

In a step management device according to one aspect of the present disclosure, a holder holding one or a plurality of processing target objects is attached with correspondence information associated with the holder, the correspondence information is conveyed integrally with the holder and can be read by the reading machine provided in a predetermined region near the facility where the step is performed, and the step management device including a start determination unit that, by reading the correspondence information by the reading machine corresponding to the step before the step, sets, as a start time, a time at which an instruction to present the presentation unit installed in the predetermined region a work instruction document indicating work content of the step is issued.

According to the above configuration, since the time at which correspondence information is read in order to present the work instruction document required for performing the work is set as a start time, the start time can be reliably decided.

A step management device according to one aspect of the present disclosure includes a detector configured to detect that a person in charge of a step that is a target to be performed has entered a predetermined range near a facility where the step is performed, and includes a warning unit configured to issue a warning when the reading is not performed within a predetermined time after the detector detects that the person in charge has entered the predetermined range, and when the reading is performed after the warning, the start determination unit sets, as a start time, a time at which the person in charge entered the predetermined range or a time after a lapse of a predetermined time from the time.

A step management device according to one aspect of the present disclosure may include a delay notification transmission unit that transmits delay notification to an external management device when the completion time is behind a predetermined schedule.

According to the above configuration, when the completion time is behind the schedule, it is possible to notify so.

In a step management device according to one aspect of the present disclosure, a step that is a target to be performed requires measurement processing of a processing target object at an end of the step, and the step management device may include a completion determination unit that sets, as a completion time, a time after a predetermined time elapses after a measurement machine used for the measurement processing is removed from a predetermined storage position or a time at which the measurement machine is returned to the storage position.

According to the above configuration, a completion time is decided by using the fact that the measurement machine used for measurement processing required at the end of the step is removed from a predetermined storage position or returned to the storage position. The fact that the measurement machine is removed from the storage position indicates that the measurement machine is used, that is, the step processing is in the final stage. Therefore, the completion time can be reliably decided by setting, as a completion time, the time after a predetermined time elapses after the measurement machine is removed from a predetermined storage position or the time at which the measurement machine is returned to the storage position.

The step management device according to each of the aspects of the present disclosure may be implemented by a computer, and in this case, a control program for a step management device that causes a computer to implement the step management device by causing the computer to operate as each unit (software element) included in the step management device, and a computer-readable recording medium recording the control program are also included in the scope of the present disclosure.

The present disclosure is not limited to each of the embodiments described above, and various modifications can be made within the scope indicated by the claims, and an embodiment obtained by appropriately combining technical means disclosed in different embodiments is also included in a technical scope of the present disclosure. New technical features can be formed by combining the technical means disclosed in each embodiment.

### REFERENCE SIGNS

1010, 1010' Controller
1011 State determination unit
1012 Time measurement unit (time calculation unit)
1013 Difference information output unit
1014 Determination pattern decision unit (minimum combination decision unit)
1020 Storage
1021 Determination table
1030 Signal acquiring unit
1040 Operation reception unit
1050 Display unit
1060 Communicator
10100, 10100' State determination device
10101 Ceramic manufacturing system
10110 State determination system
10151 Measurement unit
10200 Molding device
10300 Cutting device
10400 Firing device
10500 Grinding device
201 Production system
202 Control device
203 Storage device
204 Scheduling device
2041 Individual control device
2042 Individual storage device
205 Measurement device
206 Display
207 Notification device
3010, 3010A Controller
3011 Start/completion determination unit (start determination unit, completion determination unit)
3012 Clock unit
3013 Warning unit
3020 Storage
3021A, 3021B, 3021C Determination information
3030 Acquiring unit
3040 Operation reception unit
3050 Display unit
3060 Communicator
30100, 30100A, 30100B, 30100C Step management device
30101 Ceramic manufacturing system
30110 Step management system
30151, 30155 Detector
30152 Tag
30160 Reading unit
30200 Molding device
30300 Cutting device
30400 Firing device
30500 Grinding device
30600: Presentation unit
30700 Person-in-charge terminal (communication terminal)

## Claims

1. A state determination device comprising:
a signal acquiring unit configured to acquire a signal corresponding to each electrical wiring line of a plurality of electrical wiring lines constituting target electrical equipment in association with the each electrical wiring line, the signal indicating an energization state of the each electrical wiring line; and
a state determination unit configured to determine an operating state of the target electrical equipment that can be distinguished by a combination of energization states corresponding to the energization state of the each electrical wiring line of the plurality of electrical wiring lines.

2. The state determination device according to claim 1, wherein
a plurality of operating states are determined by the state determination unit, and
the state determination unit is configured to identify, by using the combination of energization states, which of the plurality of operating states the target electrical equipment may be in.

3. The state determination device according to claim 1 or 2, further comprising:
a time calculation unit configured to calculate a time for which the state determination unit makes a determination of being in a certain operating state of the plurality of operating states.

4. The state determination device according to any one of claims 1 to 3, further comprising:
a difference information output unit configured to compare an energization state of a certain electrical wiring line of the plurality of electrical wiring lines in a first operating state of the target electrical equipment to another operating state of the certain electrical wiring line in another operating state of the target electrical equipment, and to output difference information indicating whether there is a difference.

5. The state determination device according to any one of claims 1 to 4, further comprising:
a minimum combination decision unit that is configured to compare combinations of energization states of the plurality of electrical wiring lines among the plurality of operating states in the target electrical equipment, and to decide upon a minimum combination of the plurality of electrical wiring lines with which the plurality of operating states can be distinguished from one another.

6. A state determination system comprising:
the state determination device according to any one of claims 1 to 5; and
a current sensor that is installed in the each electrical wiring line of the plurality of electrical wiring lines constituting the target electrical equipment, the current sensor configured to transmit a signal indicating an energization state of any specific electrical wiring line of the plurality of electrical wiring lines based on a measured current value, by the current sensor, of the any specific electrical wiring line, wherein
the signal acquiring unit acquires the signal from the current sensor.

7. A production system comprising:
a storage device configured to store scheduled operating times of a plurality of facilities used for manufacturing of a product;
a measurement device configured to measure operating times of the plurality of facilities used for the manufacturing of the product based on a determination result of the state determination device according to any one of claims 1 to 5;
a display configured to display progress of the manufacturing of the product; and
a control device configured to
acquire the scheduled operating times of the plurality of facilities from the storage device,
acquire actual operating times of the plurality of facilities from the measurement device, and
control the display to display the acquired scheduled operating times and actual operating times.

8. The production system according to claim 7, wherein
the control device causes the display to display a progress rate of manufacturing in the plurality of facilities based on the scheduled operating times and the actual operating times.

9. The production system according to claim 8, wherein
the control device causes the display to express the progress rate in a display form that changes in accordance with transition of the progress rate.

10. The production system according to claims 7 to 9, wherein
the control device is configured to control the display to provide a notification when the actual operating times exceed the scheduled operating times.

11. The production system according to claims 7 to 10 further comprising:
a notification device configured to notify a user,
wherein the control device, when the actual operating times exceed the scheduled operating times, and the actual operating times exceed a predetermined time, is configured to cause the notification device to notify the user accordingly.

12. The production system according to claim 7 to 11, wherein
the control device is configured to cause the storage device to store a time difference between the scheduled operating times and the actual operating times.

13. The production system according to claim 12, further comprising:
a scheduling device configured to manage a schedule of manufacturing a product, wherein
the control device is configured
to change the scheduled operating times of the storage device based on the time difference between the scheduled operating times and the actual operating times, and
to cause the scheduling device to manage the schedule based on the scheduled operating times after being changed.

14. A step management device comprising:
a detector configured to detect that a processing target object has entered a predetermined range near a facility where a step is performed; and
a start determination unit configured to set a start time as a time at which the detector detects that the processing target object has entered the predetermined range or a time after a lapse of a predetermined time from the time at which the detector detects that the process target object has entered the predetermined range,
wherein
the display included in the production system according to any one of claims 7 to 13 is caused to display the start time.

15. A state determination method for determining a state of target electrical equipment, the state determination method comprising:
signal acquisition of acquiring a signal corresponding to each electrical wiring line of a plurality of electrical wiring lines constituting the target electrical equipment in association with the each electrical wiring line, the signal indicating an energization state of the each electrical wiring line; and
state determination of determining an operating state of the target electrical equipment that can be distinguished by a combination of energization states corresponding to the energization state of the each electrical wiring line of the plurality of electrical wiring lines.
